# EUROPÄISCHE PATENTSCHRIFT

(11) **EP 1 921 908 B1**
(45) Veröffentlichungstag und Bekanntmachung des Hinweises auf die Patenterteilung: **01.08.2012**
(21) Anmeldenummer: 07021363.2
(22) Anmeldetag: 02.11.2007
(51) Int. Cl.: H05K 1/11, H05K 3/32, H05K 7/14

(54) **Schaltungsanordnung mit einem Leistungsmodul, das mit einer Leiterplatte kombiniert ist**
Circuit assembly with a power module that is combined with a circuit board
Circuit avec un module de puissance combiné à une carte à circuit

(30) Priorität: 08.11.2006 DE 102006052619
(43) Veröffentlichungstag der Anmeldung: 14.05.2008
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- DE-A1- 19 630 173
- DE-A1-102005 024 900
- JP-A- 2005 217 075
- US-B1- 6 417 747

## Beschreibung

Die Erfindung betrifft eine Schaltungsanordnung mit einem Leistungsmodul, das mit einer Leiterplatte kombiniert ist, wobei das Leistungsmodul und die Leiterplatte zwischen einem Kühlkörper und einer Presseinrichtung vorgesehen und miteinander durch Druckkontaktelemente druckkontaktiert sind, wobei das Leistungsmodul mindestens ein Modul-Plattenelement und ein Gehäuse aufweist, das mit Schächten für die Druckkontaktelemente ausgebildet ist, die mit dem mindestens einen Modul-Plattenelement und der Leiterplatte kontaktiert sind, wobei die Schächte aus der der Leiterplatte zugewandten Grundfläche des Gehäuses an Mündungsöffnungen ausmünden.

Einen Ausgangspunkt bildet die DE 10 2005 024 900 A1, die eine Schaltungsanordnung mit einem Leistungsmodul offenbart, das mit einer Leiterplatte kombiniert ist. Die Leiterplatte und das Leistungsmodul sind zwischen einem Kühlkörper und einer Presseinrichtung vorgesehen und durch Druckkontaktierungselemente druckkontaktiert. Das Leistungsmodul weist ein Modul-Plattenelement und ein Gehäuse auf, das mit Schächten für die Druckkontaktelemente ausgebildet ist.

Ebenfalls bekannt sind Leistungsmodule, wie sie in der DE 196 30 173 A1 beschrieben sind. In dieser Druckschrift wird ein Leistungsmodul zur direkten Montage auf einem Kühlkörper offenbart, bestehend aus einem Gehäuse und einem elektrisch isolierenden Substrat welches seinerseits aus einem Isolierstoffkörper mit einer Mehrzahl darauf befindlicher gegeneinander isolierter metallischer Verbindungsbahnen und darauf befindlichen und mit diesen Verbindungsbahnen schaltungsgerecht verbundenen Leistungshalbleiterbauelementen besteht. Die externe elektrische Verbindung zu einer außerhalb des Gehäuses angeordnete Leiterplatte erfolgt mittels zumindest teilweise federnd gestalteten Anschlusselementen.

In der US 6 417 747 B1 wird ein Modul mit einem Gehäuse und einem PWB beschrieben, bei dem das Gehäuse mittels einer Klebevorrichtung mit dem PWB befestigt wird. Weiterhin weist das Gehäuse Pins auf, die für eine zusätzliche Verbindung im PWB befestigt werden. Hierfür weist die Klebevorrichtung und das PWB Ausnehmungen auf.

Die JP 2005217075 A beschreibt eine Anordnung, bei der Vibrationen und Belastungen auf eine Leiterplatte vermieden werden sollen. Das erfolgt mittels einem oberen und einem unteren Gehäuse, die die Leiterplatte einklemmen. Zusätzlich wird auf oder unter die Leiterplatte ein Dichtungselement angeordnet, das elastisch ausgelegt ist.

Bei derartigen Schaltungsanordnungen kann nicht zuverlässig ausgeschlossen werden, dass es unter extremen Klimabedingungen, wie beispielsweise einer extremen Feuchtebeaufschlagung mit zwischenzeitlicher Betauung, zu einem Ausfall der Schaltungsanordnung kommt. Derartige Ausfälle sind insbesondere durch eine Korrosion des mindestens einen Modul-Plattenelements des Leistungsmoduls, der Druckkontaktelemente und/oder der Leiterplatte bedingt.

Der Erfindung liegt deshalb die Aufgabe zugrunde, eine Schaltungsanordnung der eingangs genannten Art zu schaffen, bei der mit einfachen Mitteln eine Korrosion des Leistungsmoduls, der Druckkontaktelemente und/oder der Leiterplatte verhindert und ein daraus resultierender Ausfall der Schaltungsanordnung vermieden wird.

Diese Aufgabe wird bei einer Schaltungsanordnung der eingangs genannten Art erfindungsgemäss durch die Merkmale des Anspruchs 1, d.h. dadurch gelöst, dass die Grundfläche des Gehäuses um die Mündungsöffnungen der für die Druckkontaktelemente vorgesehenen Schächte herum mit Öffnungs-Dichtrippen ausgebildet ist wobei die Öffnungs-Dichtrippen direkt und unmittelbar dicht an der Leiterplatte anliegen. Diese Öffnungs-Dichtrippen können einzelnen Mündungsöffnungen oder Gruppen von Mündungsöffnungen zugeordnet sein.

Durch diese Öffnungs-Dichtrippen ergibt sich der Vorteil, dass ein Eindringen von Feuchtigkeit verhindert und folglich Korrosionen an der Leiterplatte, den Druckkontaktelementen und/oder dem Leistungsmodul vermieden werden.

Die erfindungsgemässe Schaltungsanordnung besitzt folglich eine optimale Betriebszuverlässigkeit und Lebensdauer.

Bei der erfindungsgemässen Schaltungsanordnung können die Öffnungs-Dichtrippen aus dem Material des Gehäuses bestehen, d.h. mit dem Gehäuse in einem Herstellungsprozess integral ausgebildet sein. Eine andere Möglichkeit besteht darin, dass die an den Mündungsöffnungen der Grundfläche des Gehäuses vorgesehenen Öffnungs-Dichtrippen aus einem nachgiebigen Material bestehen. Derartige Öffnungs-Dichtrippen der zuletzt genannten Art können beispielsweise auf die Grundfläche des Gehäuses aufgedruckt werden; eine andere Möglichkeit besteht darin, das Gehäuse in einem 2K-Spritzverfahren herzustellen, wobei das Gehäuse aus einem formstabilen harten Material und die Öffnungs-Dichtrippen aus einem nachgiebigen Material bestehen und in einem gemeinsamen Herstellungsprozess an der Grundfläche des Gehäuses bei der Realisierung desselben hergestellt werden.

Unabhängig davon, ob die Öffnungs-Dichtrippen mit dem Gehäusematerial einstückig oder aus einem vom Gehäusematerial verschiedenen, relativ nachgiebigen Material hergestellt werden, ergibt sich durch die den einzelnen Mündungsöffnungen oder Gruppen von Mündungsöffnungen zugeordneten Öffnungs-Dichtrippen eine gute Abdichtung zwischen der Grundfläche des Gehäuses des Leistungsmoduls und der dieser benachbarten Leiterplatte

Eine weitere Verbesserung der Abdichteigenschaften der erfindungsgemässen Schaltungsanordnung ergibt sich, wenn die Grundfläche des Gehäuses des Leistungsmoduls entlang ihres Aussenrandes eine umlaufende Randdichtrippe aufweist. Diese umlaufende Randdichtrippe kann - wie die Öffnungs-Dichtrippen - aus dem Material des Gehäuses bestehen und mit dem Gehäusematerial einstückig ausgebildet sein, oder die umlaufende Randdichtrippe besteht aus einem nachgiebigen Material und wird am Aussenrand der Grundfläche des Gehäuses des Leistungsmoduls vorgesehen.

Bezüglich der umlaufenden Randdichtrippe gelten die oben zu den Öffnungs-Dichtrippen gemachten Ausführungen entsprechend.

Noch weiter verbesserte Abdichteigenschaften bzw. eine optimale Abdichtung ergibt sich bei der erfindungsgemässen Schaltungsanordnung; wenn zwischen der Leiterplatte und der Grundfläche des Gehäuses ein Abdichtflächenelement vorgesehen ist, das mit Ausnehmungen für die Druckkontaktelemente ausgebildet ist. Das Abdichtflächenelement ist vorzugsweise von einer Kunststofffolie gebildet. Bei dieser Folie kann es sich beispielsweise um eine PTFE-Folie handeln, die im Temperaturbereich zwischen -20 und +260 °C einsetzbar ist, die säure-, laugen-, benzin- und ölbeständig und unbrennbar ist und folglich dem Brandverhalten UL94VO entspricht.

Selbstverständlich kann das Abdichtflächenelement auch aus einem anderen geeigneten Material bestehen.

Zweckmässigerweise ist das Abdichtflächenelement mit Aussenabmessungen ausgebildet, die den Randabmessungen der Grundfläche des Gehäuses des Leistungsmoduls entsprechen, d.h. die gleich gross oder geringfügig grösser sind als die Grundfläche des Gehäuses.

Weitere Einzelheiten, Merkmale und Vorteile ergeben sich aus der nachfolgenden Beschreibung eines in der Zeichnung schematisch verdeutlichten Ausführungsbeispiels der erfindungsgemässen Schaltungsanordnung bzw. wesentliche Einzelheiten derselben.

### Es zeigen -:

- Figur 1: abschnittweise in einer Seitenansicht nicht massstabgetreu eine Ausführungsform der Schaltungsanordnung,
- Figur 2: eine Ansicht in Blickrichtung der Pfeile II-II in Figur 1 auf einen Abschnitt der Grundfläche des Gehäuses des Leistungsmoduls der Schaltungsanordnung,
- Figur 3: eine der Figur 2 ähnliche abschnittweise Draufsicht auf eine andere Ausbildung des Gehäuses des Leistungsmoduls der Schaltungsanordnung,
- Figur 4: einen Schnitt entlang der Schnittlinie IV-IV in Figur 2 in einem grösseren Massstab,
- Figur 5: einen Schnitt entlang der Schnittlinie V-V in Figur 2 in einem grösseren Massstab,
- Figur 6: eine der Figur 5 ähnliche abschnittweise Schnittdarstellung einer anderen Ausbildung der Schaltungsanordnung,
- Figur 7: eine der Figur 4 ähnliche abschnittweise Schnittdarstellung der Ausbildung der Schaltungsanordnung gemäss Figur 6,
- Figur 8: eine perspektivische Ansicht eines Abdichtflächenelements einer Schaltungsanordnung gemäss den Figuren 6 und 7,
- Figur 9: eine Ansicht des Abdichtflächenelements in Blickrichtung von oben,
- Figur 10: eine perspektivische Ansicht einer Ausbildung des Gehäuses des Leistungsmoduls der Schaltungsanordnung, und
- Figur 11: eine Ansicht des Gehäuses gemäss Figur 1 in Blickrichtung von oben.

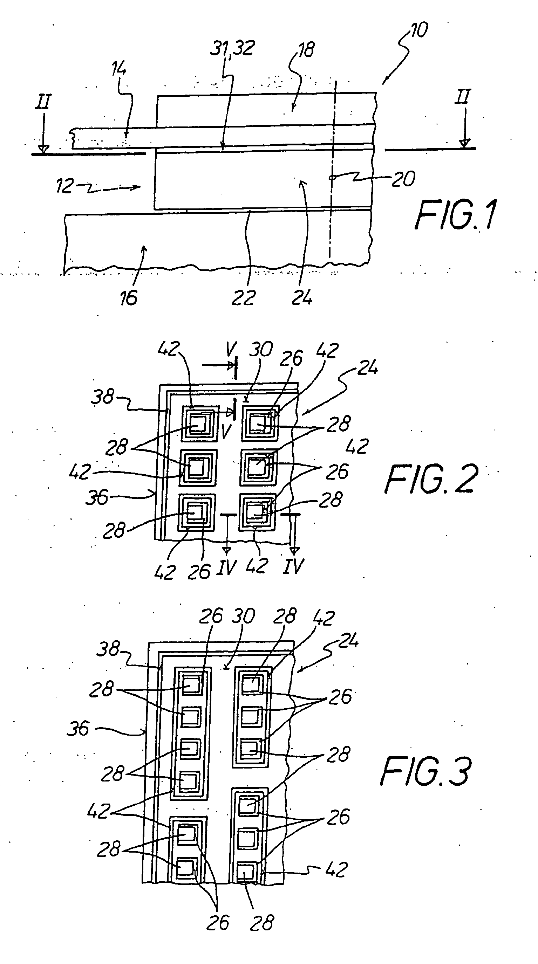

Figur 1 verdeutlicht schematisch abgeschnitten in einer Seitenansicht eine Ausbildung der Schaltungsanordnung 10 mit einem Leistungsmodul 12, das mit einer Leiterplatte 14 kombiniert ist. Das Leistungsmodul 12 und die Leiterplatte 14 sind zwischen einem abgeschnitten gezeichneten Kühlkörper 16 und einer Presseinrichtung 18 vorgesehen und miteinander in an sich bekannter Weise druckkontaktiert.

Zum Verpressen der Leiterplatte 14 mit dem Leistungsmodul 12 wird die Presseinrichtung 18 mit dem Kühlkörper 16 verspannt. Dieses Verspannen erfolgt beispielsweise mit Hilfe mindestens einer Schraube, die in Figur 1 durch eine strichpunktierte Linie 20 schematisch verdeutlicht ist.

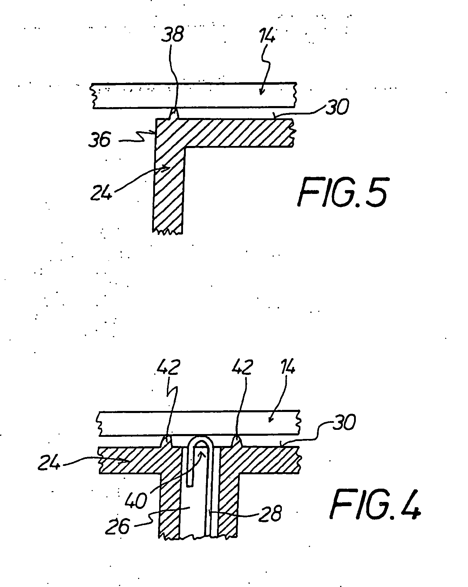

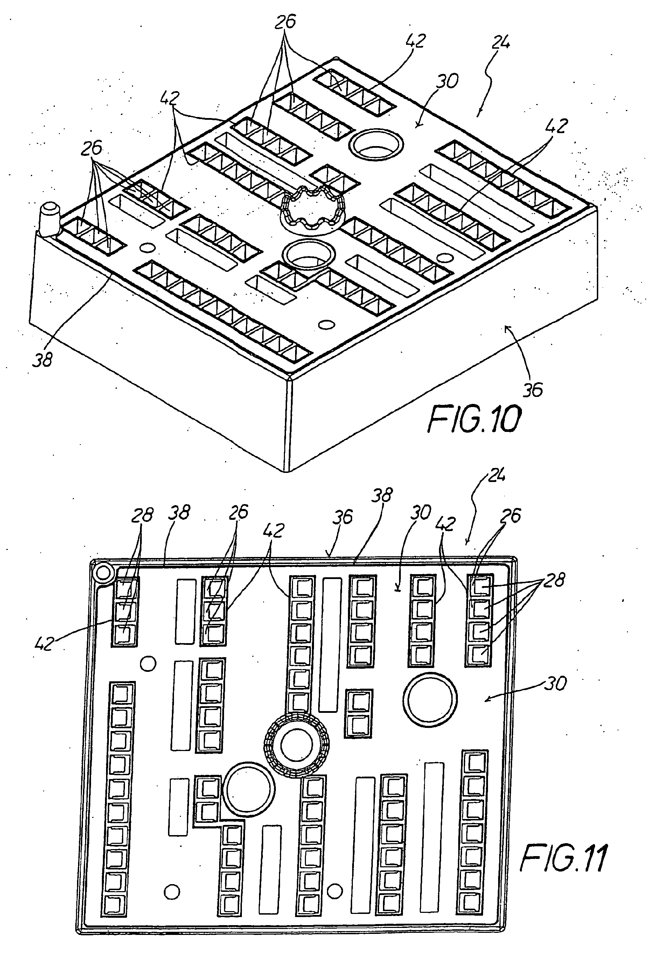

Das Leistungsmodul 12 weist in an sich bekannter Weise mindestens ein Modul-Plattenelement 22 und ein becherförmiges Gehäuse 24 auf. Das becherförmige Gehäuse 24 ist mit Schächten 26 (sh. die Figuren 2, 3, 4, 10 und 11) ausgebildet. Die Schächte 26 sind für Druckkontaktelemente 28 (sh. die Figuren 2, 3, 4, 7 und 11) vorgesehen. Die Druckkontaktelemente 28 dienen zur an sich bekannten Druckkontaktierung des mindestens einen Modul-Plattenelements 22 mit der Leiterplatte 14.

Um zwischen dem Leistungsmodul 12 und der Leiterplatte 14 eine zuverlässige Abdichtung gegen das Eindringen von Feuchtigkeit zu bewirken, ist zwischen der Leiterplatte 14 und der dieser zugewandten Grundfläche 30 des becherförmigen Gehäuses 24 eine Abdichtung 31 vorgesehen. Diese Abdichtung 31 ist von Öffnungs-Dichtrippen 42 (sh. die Figuren 2, 3, 4, 7, 10 und 11) gebildet, die jeweils um Mündungsöffnungen 40 der für die Druckkontaktelemente 28 vorgesehenen Schächte 26 herum vorgesehen sind. Die Offnungs-Dichtrippen 42 können dabei jeweils einzelnen Schächten 26 (sh. Figur 2) oder Gruppen von Schächten 26 (sh. Figur 3) zugeordnet sein.

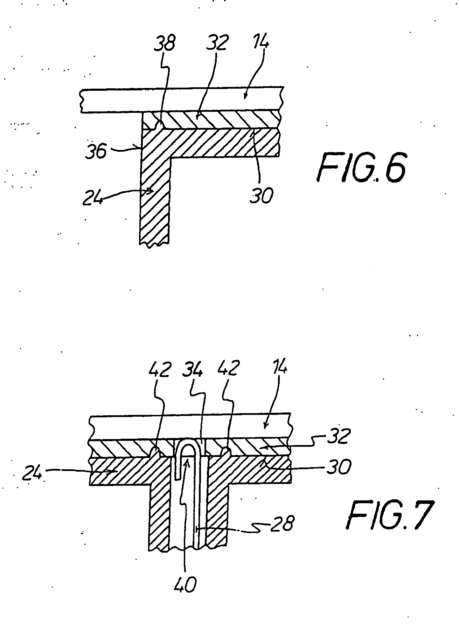

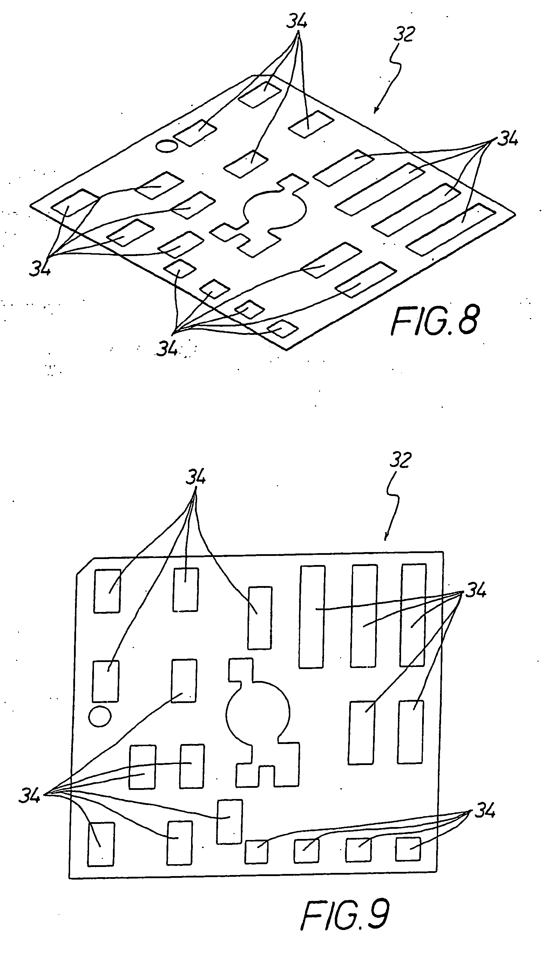

Die Öffnungs-Dichtrippen 42 liegen dabei direkt und unmittelbar dicht an der Leiterplatte 14 an, oder es ist zwischen der Leiterplatte 14 und der Grundfläche 30 des becherförmigen Gehäuses 24 ein Abdichtflächenelement 32 vorgesehen (sh. die Figuren 6 bis 9).

Die Abdichtung 31 zwischen der Leiterplatte 14 und dem becherförmigen Gehäuse 24 des Leistungsmoduls 12 kann ausserdem durch eine am Aussenrand 36 der Grundfläche 30 des becherförmigen Gehäuses 24 umlaufende Randdichtlippe 38 (sh. die Figuren 2, 3, 5, 6, 10 und 11) verbessert sein.

Das Abdichtflächenelement 32 ist mit Ausnehmungen 34 ausgebildet, die mit den Mündungsöffnungen 40 der Schächte 26 deckungsgleich vorgesehen sind und durch die sich die Druckkontaktelemente 28 hindurch erstrecken und mit der Leiterplatte 14 druckkontaktiert sind.

Gleiche Einzelheiten sind in den Figuren 1 bis 11 jeweils mit denselben Bezugsziffern bezeichnet, so dass es sich erübrigt, in Verbindung mit allen Figuren alle Einzelheiten jeweils detailliert zu beschreiben.

### Bezugsziffernliste -:

- 10: Schaltungsanordnung
- 12: Leistungsmodule (von 10)
- 14: Leiterplatte (von 10)
- 16: Kühlkörper (von 10)
- 18: Presseinrichtung (für 12 und 14)
- 20: strichpunktierte Linie / Schraube (zwischen 18 und 16)
- 22: Modul-Plattenelement (von 12)
- 24: becherförmiges Gehäuse (von 12 für 22)
- 26: Schächte (in 24 für 28)
- 28: Druckkontaktelemente (zwischen 12 und 14)
- 30: Grundfläche (von 24)
- 31: Abdichtung (zwischen 14 und 12)
- 32: Abdichtflächenelement (zwischen 12 und 14)
- 34: Ausnehmungen (in 32)
- 36: Aussenrand (von 24 bzw. 30)
- 38: Randdichtrippe (an 36)
- 40: Mündungsöffnungen (von 26 bei 30)
- 42: Öffnungs-Dichtrippen (bei 40)

## Patentansprüche

1. Schaltungsanordnung (10) mit einem Leistungsmodul (12), das mit einer Leiterplatte (14) kombiniert ist, wobei das Leistungsmodul (12) und die Leiterplatte (14) zwischen einem Kühlkörper (16) und einer Presseinrichtung (18) vorgesehen und miteinander durch Druckkontaktierungselemente (28) druckkontaktiert sind, wobei das Leistungsmodul (12) mindestens ein Modul-Plattenelement (22) und ein Gehäuse (24) aufweist, das mit Schächten (26) für die Druckkontaktelemente (28) ausgebildet ist, die mit dem mindestens einen Modul-Plattenelement (22) und der Leiterplatte (14) druckkontaktiert sind, wobei die Schächte (26) aus der der Leiterplatte (14) zugewandten Grundfläche (30) des Gehäuses (24) an Mündungsöffnungen (40) ausmünden, und die Grundfläche (30) des Gehäuses (24) um die Mündungsöffnungen (40) der für die Druckkontaktelemente (28) vorgesehenen Schächte (26) herum mit Öffnungs-Dichtrippen (42) ausgebildet ist, wobei die Öffnungs-Dichtrippen (42) direkt und unmittelbardicht an der Leiterplatte (14) anliegen.

2. Schaltungsanordnung nach Anspruch 1,
**dadurch gekennzeichnet,**
**dass** die Öffnungs-Dichtrippen (42) einzelnen Mündungsöffnungen (40) und/oder Gruppen von Mündungsöffnungen (40) zugeordnet sind.

3. Schaltungsanordnung nach Anspruch 1 oder 2,
**dadurch gekennzeichnet,**
**dass** die Öffnungs-Dichtrippen (42) aus dem Material des becherförmigen Gehäuses (24) bestehen und mit dem becherförmigen Gehäuse (24) material-einstückig ausgebildet sind.

4. Schaltungsanordnung nach Anspruch 1 oder 2,
**dadurch gekennzeichnet,**
**dass** die Öffnungs-Dichtrippen (42) aus einem nachgiebigen Material bestehen und an den Mündungsöffnungen (40) der Grundfläche (30) des becherförmigen Gehäuses (24) vorgesehen sind.

5. Schaltungsanordnung nach einem der Ansprüche 1 bis 4,
**dadurch gekennzeichnet,**
**dass** die Grundfläche (30) des becherförmigen Gehäuses (24) entlang ihres Aussenrandes (36) eine umlaufende Randdichtrippe (38) aufweist.

6. Schaltungsanordnung nach Anspruch 5,
**dadurch gekennzeichnet,**
**dass** die umlaufende Randdichtrippe (38) aus dem Material des becherförmigen Gehäuses (24) besteht und mit dem becherförmigen Gehäuse (24) material-einstückig ausgebildet ist.

7. Schaltungsanordnung nach Anspruch 5,
**dadurch gekennzeichnet,**
**dass** die umlaufende Randdichtrippe (38) aus einem nachgiebigen Material besteht und am Aussenrand (36) der Grundfläche (30) des becherförmigen Gehäuses (24) vorgesehen ist.

8. Schaltungsanordnung (10) mit einem Leistungsmodul (12), das mit einer Leiterplatte (14) kombiniert ist, wobei das Leistungsmodul (12) und die Leiterplatte (14) zwischen einem Kühlkörper (16) und einer Presseinrichtung (18) vorgesehen und miteinander durch Druckkontaktierungselemente (28) druckkontaktiert sind, wobei das Leistungsmodul (12) mindestens ein Modul-Plattenelement (22) und ein Gehäuse (24) aufweist, das mit Schächten (26) für die Druckkontaktelemente (28) ausgebildet ist, die mit dem mindestens einen Modul-Plattenelement (22) und der Leiterplatte (14) druckkontaktiert sind, wobei die Schächte (26) aus der der Leiterplatte (14) zugewandten Grundfläche (30) des Gehäuses (24) an Mündungsöffnungen (40) ausmünden, und die Grundfläche (30) des Gehäuses (24) um die Mündungsöffnungen (40) der für die Druckkontaktelemente (28) vorgesehenen Schächte (26) herum mit Öffnungs-Dichtrippen (42) ausgebildet ist, wobei zwischen der Leiterplatte (14) und der Grundfläche (30) des becherförmigen Gehäuses (24) ein Abdichtflächenelement (32) vorgesehen ist, das mit Ausnehmungen (34) für die Druckkontaktelemente (28) ausgebildet ist.

9. Schaltungsanordnung nach Anspruch 8,
**dadurch gekennzeichnet,**
**dass** das Abdichtflächenelement (32) Aussenabmessungen aufweist, die den Randabmessungen der Grundfläche (30) des becherförmigen Gehäuses (24) entsprechen.

10. Schaltungsanordnung nach Anspruch 8,
**dadurch gekennzeichnet,**
**dass** das Abdichtflächenelement (32) von einer Kunststofffolie gebildet ist.

## Claims

1. Circuit arrangement (10) with a power module (12) which is combined with a printed circuit board (14), wherein the power module (12) and the printed circuit board (14) are provided between a cooling body (16) and a pressing device (18) and are push-contacted with one another by push-contacting elements (28), wherein the power module (12) has at least one module plate element (22) and a housing (24) which is designed with shafts (26) for the push-contact elements (28) which are push-contacted with the at least one module plate element (22) and the printed circuit board (14), wherein the shafts (26) open out from the base surface (30) of the housing (24) facing the printed circuit board (14) at orifice openings (40), and the base surface (30) of the housing (24) is designed with opening sealing ribs (42) around the orifice openings (40) of the shafts (26) provided for the push-contact elements (28), wherein the opening sealing ribs (42) rest directly and indirectly fully on the printed circuit board (14).

2. Circuit arrangement according to claim 1, **characterised in that** the opening sealing ribs (42) are assigned to individual orifice openings (40) and/or groups of orifice openings (40).

3. Circuit arrangement according to claim 1 or 2, **characterised in that** the opening sealing ribs (42) consist of the material of the cup-shaped housing (24) and are designed to be materially in one piece with the cup-shaped housing (24).

4. Circuit arrangement according to claim 1 or 2, **characterised in that** the opening sealing ribs (42) consist of a flexible material and are provided at the orifice openings (40) of the base surface (30) of the cup-shaped housing (24).

5. Circuit arrangement according to one of claims 1 to 4, **characterised in that** the base surface (30) of the cup-shaped housing (24) has an annular edge sealing rib (38) along its outer edge (36).

6. Circuit arrangement according to claim 5, **characterised in that** the annular edge sealing rib (38) consists of the material of the cup-shaped housing (24) and is designed to be materially in one piece with the cup-shaped housing (24).

7. Circuit arrangement according to claim 5, **characterised in that** the annular edge sealing rib (38) consists of a flexible material and is provided on the outer edge (36) of the base surface (30) of the cup-shaped housing (24).

8. Circuit arrangement (10) with a power module (12) which is combined with a printed circuit board (14), wherein the power module (12) and the printed circuit board (14) are provided between a cooling body (16) and a pressing device (18) and are push-contacted with one another by push-contacting elements (28), wherein the power module (12) has at least one module plate element (22) and a housing (24) which is designed with shafts (26) for the push-contact elements (28) which are push-contacted with the at least one module plate element (22) and the printed circuit board (14), wherein the shafts (26) open out from the base surface (30) of the housing (24) facing the printed circuit board (14) at orifice openings (40), and the base surface (30) of the housing (24) is designed with opening sealing ribs (42) around the orifice openings (40) of the shafts (26) provided for the push-contact elements (28), wherein a sealing surface element (32), which is designed with recesses (34) for the push-contact elements (28), is provided between the printed circuit board (14) and the base surface (30) of the cup-shaped housing (24).

9. Circuit arrangement according to claim 8, **characterised in that** the sealing surface element (32) has external dimensions which correspond to the edge dimensions of the base surface (30) of the cup-shaped housing (24).

10. Circuit arrangement according to claim 8, **characterised in that** the sealing surface element (32) is formed by a plastic film.

## Revendications

1. Agencement de circuit (10) comprenant un module de puissance (12), qui est combiné avec une carte à circuits imprimés (14), le module de puissance (12) et la carte à circuits imprimés (14) étant prévus entre un corps réfrigérant (16) et un système de compression (18) et étant en contact par pression l'un avec l'autre par des éléments de mise en contact par pression (28), le module de puissance (12) présentant au moins un élément de plaque à module (22) et un boîtier (24), qui est conçu avec des puits (26) pour les éléments de mise en contact par pression (28), lesquels sont mis en contact par pression avec l'au moins un élément de plaque à module (22) et la carte à circuits imprimés (14), les puits (26) débouchant de la surface de base (30), associée à la carte à circuits imprimés (14), du boîtier (24) sur des orifices de débouché (40), et la surface de base (30) du boîtier (24) étant conçue autour des orifices de débouché (40) des puits (26), prévus pour les éléments de contact par pression (28), avec des nervures d'étanchéité d'ouverture (42), les nervures d'étanchéité d'ouverture (42) s'appliquant directement de façon étanche sur la carte à circuits imprimés (14).

2. Agencement de circuit selon la revendication 1, **caractérisé en ce que** :
les nervures d'étanchéité d'ouverture (42) sont attribuées à des orifices de débouché individuels (40) et/ou des groupes d'orifices de débouché (40).

3. Agencement de circuit selon la revendication 1 ou 2, **caractérisé en ce que** :
les nervures d'étanchéité d'ouverture (42) sont à base du matériau du boîtier (24) en forme de gobelet et sont conçues d'un seul tenant au niveau du matériau avec le boîtier (24) en forme de gobelet.

4. Agencement de circuit selon la revendication 1 ou 2, **caractérisé en ce que** :
les nervures d'étanchéité d'ouverture (42) sont à base d'un matériau souple et sont prévues sur les orifices de débouché (40) de la surface de base (30) du boîtier (24) en forme de gobelet.

5. Agencement de circuit selon l'une des revendications 1 à 4, **caractérisé en ce que** :
la surface de base (30) du boîtier (24) en forme de gobelet présente une nervure d'étanchéité de bord (38) périphérique le long de son bord extérieur (36).

6. Agencement de circuit selon la revendication 5, **caractérisé en ce que** :
la nervure d'étanchéité de bord (38) périphérique est à base du matériau du boîtier (24) en forme de gobelet et est conçue d'un seul tenant au niveau du matériau avec le boîtier (24) en forme de gobelet.

7. Agencement de circuit selon la revendication 5, **caractérisé en ce que** :
la nervure d'étanchéité de bord (38) périphérique est à base d'un matériau souple et est prévue sur le bord extérieur (36) de la surface de base (30) du boîtier (24) en forme de gobelet.

8. Agencement de circuit (10) avec un module de puissance (12), qui est combiné avec une carte à circuits imprimés (14), le module de puissance (12) et la carte à circuits imprimés (14) étant prévus entre un corps réfrigérant (16) et un dispositif de compression (18) et étant mis en contact l'un avec l'autre par pression par des éléments de mise en contact par pression (28), le module de puissance (12) présentant au moins un élément de plaque à module (22) et un boîtier (24), qui est conçu avec des puits (26) pour les éléments de mise en contact par pression (28), lesquels sont mis en contact par pression avec l'au moins un élément de plaque à module (22) et la carte à circuits imprimés (14), les puits (26) débouchant de la surface de base (30), tournée vers la carte à circuits imprimés (14), du boîtier (24) sur des orifices de débouché (40), et la surface de base (30) du boîtier (24) étant conçue avec des nervures d'étanchéité d'ouverture (42) autour des orifices de débouché (40) des puits (26) prévus pour les éléments de mise en contact par pression (28), un élément de surface d'étanchéité (32) étant prévu entre la carte à circuits imprimés (14) et la surface de base (30) du boîtier (24) en forme de gobelet, lequel élément est conçu avec des évidements (34) pour les éléments de contact par pression (28).

9. Agencement de circuit selon la revendication 8, **caractérisé en ce que** :
l'élément de surface d'étanchéité (32) présente des dimensions extérieures, qui correspondent aux dimensions de bord de la surface de base (30) du boîtier (24) en forme de gobelet.

10. Agencement de circuit selon la revendication 8, **caractérisé en ce que** :
l'élément de surface d'étanchéité (32) est formé d'un film en matière plastique.
